# EUROPEAN PATENT SPECIFICATION

(11) **EP 1 330 681 B1**
(45) Date of publication and mention of the grant of the patent: **18.09.2013**
(21) Application number: 01977412.4
(22) Date of filing: 02.10.2001
(51) Int. Cl.: G03F 9/00

(54) **SYSTEM AND METHOD FOR FACILITATING WAFER ALIGNMENT BY MITIGATING EFFECTS OF RETICLE ROTATION ON OVERLAY**
SYSTEM UND VERFAHREN ZUM ERLEICHTERN DER WAFERAUSRICHTUNG BEI MINDERUNG DES ROTATIONEFFEKTS VON STRICHPLATTEN IN ÜBERLAGERUNG
SYSTÈME ET PROCÉDÉ DESTINÉS À FACILITER L'ALIGNEMENT DE PLAQUETTES, PERMETTANT D'ATTENUER LES EFFETS DE ROTATION DE RÉTICULE SUR LA SUPERPOSITION

(30) Priority: 23.10.2000 US 242574 P; 20.02.2001 US 788905
(43) Date of publication of application: 30.07.2003
(73) Proprietor: ADVANCED MICRO DEVICES, INC., Sunnyvale CA 94088-3453 (US)
(72) Inventor: TEMPLETON, Michael, K., Goleta, CA 93118-8238 (US); RANGARAJAN, Bharath, Santa Clara, CA 95050 (US)
(74) Representative: Wright, Hugh Ronald
(86) International application number: PCT/US2001/030931
(87) International publication number: WO 2002/035288

(56) References cited:
- EP-A- 0 226 905
- EP-A- 0 358 425
- EP-A- 0 895 279
- WO-A-01/29618
- US-A- 4 595 295
- US-A- 4 677 301
- US-A- 4 769 523
- US-A- 5 262 258
- US-A- 5 272 501
- US-A- 5 656 229
- US-A- 5 699 260
- US-B1- 6 269 322

## Description

### TECHNICAL FIELD

The present invention generally relates to semiconductor processing, and in particular to a system and method for facilitating wafer alignment by mitigating effects of reticle rotation on overlay.

### BACKGROUND ART

The tendency of semiconductor devices such as integrated circuits (IC) and large scale integrated circuits (LSIC) toward minuteness has rapidly progressed, and higher accuracy has been required of apparatuses for manufacturing such semiconductor devices. In particular, such requirements are demanded from exposure devices in which a circuit pattern of a mask or a reticle is superposedly transferred onto a circuit pattern formed on a semiconductor wafer. It is desired that the circuit pattern of the mask and the circuit pattern of the wafer be superposed one upon the other with accuracies of, for example, less than 0.1 □m.

Semiconductor integrated circuits undergo a variety of processing steps during manufacture, such as masking, resist coating, etching, and deposition. In many of these steps, material is overlayed or removed from the existing layer at specific locations in order to form desired elements of the integrated circuit. Proper alignment of the various process layers is important. The shrinking dimensions of modern integrated circuits require increasingly stringent overlay alignment accuracy. If proper alignment tolerances are not achieved, device defects can result.

More particularly, during fabrication of an IC, a wafer lithography system projects a pattern of light onto a photoresist layer of a wafer. The projected light changes properties of exposed portions of the photoresist layer such that a subsequent development process forms a mask from the photoresist layer that exposes or protects different portions of the wafer. The masked wafer is then removed to a reaction chamber where a process such as etching changes the exposed portions of the wafer. Typically, a wafer lithography system forms several masks on a wafer during an IC fabrication process, and the masks must be aligned with each other to form a working IC.

A wafer stepper typically is used to align the wafer during the various process steps. The wafer stepper uses one of a number of commercially available techniques to generate alignment signals which indicate position relative to the wafer. The alignment signals typically are produced by optical measurement of alignment marks placed at specified locations on the wafer. A reticle is used to place the appropriate marks on a particular wafer process layer such that the marks can be readily identified by the wafer stepper in subsequent processing steps. The reticle includes a pattern which can be etched into the wafer using optical photolithography. Commonly used alignment mark techniques include Laser Step Alignment (LSA), Field Image Alignment (FIA), Laser Interferometric Alignment (LIA), Global Alignment Mark (GAM), and Global Alignment Mark Laser Step Alignment (GAMLSA). In a step-and-repeat type apparatus, the wafer is moved in steps by predetermined distances. For example, the wafer typically is placed on a two-dimensionally moveable stage and positioned relative to a projected image of a reduction projection type exposure apparatus.

Some types of alignment systems and/or methods employ large global alignment marks to align the wafer. For such systems and/or methods, a reticle includes a design pattern and an alignment mark. The alignment mark is typically located outside of the design pattern, although the alignment mark could be located within the design region but at the expense of sacrificing design area real estate. The design pattern and alignment mark are printed at several predetermined fields of a wafer. These printed alignment marks are found by a stepper system and are employed in wafer alignment, for example, for subsequent processing.

Another type of alignment system utilizes a reticle having scribe lines located along a perimeter portion of the design area. Usually, two sets of scribe lines are printed respectively along two adjacent sides of the design area, with each set of scribe lines having a standard pitch. The scribe lines and design pattern are printed at several predetermined fields of the wafer during a step-and-repeat process. The printed scribe lines extend between each adjacent field. A stepper system locates, for example, a centroid for a selected set of scribe lines to facilitate alignment between the reticle and the wafer in subsequent processing.

US patent 5,699,260 discloses a series of photolithographic procedures performed on a wafer to optimise the number of die obtained and avoid step and repeat alignment, including projecting onto the wafer images of die patterns defining layers of identical die which after formation are separated into corresponding IC parts, and using a template wafer to align a first level mask.

European patent EP0266905 discloses a method for facilitating the alignment of a photomask with individual fields on the surfaces of a number of wafers, each wafer carrying an identical array of fields produced in an previous printing process, by choosing a wafer, measuring the rotational adjustment needed to bring each field into the correct direction and use the measured value for automatic rotational adjustment of other wafers.

European patent EP0358425 discloses a device for detecting a positional relationship between a mask and a wafer.

European patent EP 0895279 discloses measurement and correction of pattern position shift errors using an electron beam drawing apparatus to enhance alignment accuracy.

US patent 4,769,523 discloses a laser processing apparatus including a mark detector for detecting the positions of preliminary marks, forming detectable marks and detecting errors.

US patent 4,677,301 discloses a position alignment apparatus for detecting misalignment of a projected pattern image on a wafer and means to responsively move the wafer.

US patent 4,595,295 discloses an alignment system for lithographic proximity printing apparatus in which a wafer and lithographic mask are each individually aligned with a third element.

US patent 5, 656, 229 discloses a removal of a resist covering a selected pattern on the surface of a wafer, dependent on alignment marks in the pattern.

US patent 5,272,501 discloses a projection exposure apparatus with an irradiation optical system for irradiating a pattern formed on a mask, including a mark detection device.

US patent 5,262,258 discloses a method for providing a reference point on a wafer including forming a composite set of scribe marks from a first and second set of scribe marks, the composite set having a geometric characteristic capable of being employed to detect a rotational error associated with a reticle in a lithographic printing process, each of the first and second sets of scribe marks having a respective centroid.

However, the reticle may have been positioned in the projection system with a slight rotation and/or the reticle may include rotation errors due to the scribe lines and associated design pattern being slightly rotated or shifted (for example, as a result of error in the process of manufacturing the reticle). The errors due to rotation or shifting of the scribe lines and design pattern become greatly exaggerated as one moves away from the center of the reticle. Another type of error is lens magnification error wherein the image (scribe lines and/or design pattern) is slightly over-magnified or under-magnified with respect to an intended magnification level. The reticle rotation error and/or lens magnification error result in the scribe lines being printed at locations different from intended. Consequently, the centroid position which is used for alignment purposes also includes position errors proportional to the reticle rotation error.

### DISCLOSURE OF THE INVENTION

The present invention relates to a system and method for facilitating wafer alignment by mitigating overlay error in the production of semiconductor devices.

One aspect of the present invention relates to a method for determining a reference point on a wafer. A composite set of scribe marks is formed from a first and second set of scribe marks. The composite set of scribe marks has a geometric characteristic which is capable of being employed as the reference point to substantially negate rotational error associated with a reticle employed in a lithographic printing process. Each of the first and second sets of scribe marks has a respective centroid. The geometric characteristic of the composite set of scribe marks being a centroid formed by aggregating respective centroids of the first and second sets of scribe marks as printed on a surface layer of the wafer.

Another aspect of the present invention relates to a method for facilitating wafer alignment using a reticle. The reticle includes a design area, a first set of scribe marks, and a second set of scribe marks symmetric to the first set of scribe marks relative to the design area. The first and second sets of scribe marks are printed on a surface layer of the wafer associated with a first field location. The first and second sets of scribe marks are printed on the surface layer of the wafer associated with a second field location adjacent to the first field location, such that the first set of printed scribe marks of the first field location and the second set of printed scribe marks of the second field location form a composite set of printed scribe marks, which is capable of being employed to substantially negate rotational error associated with the reticle employed in a lithographic printing process. Each of the first and second sets of scribe marks has a respective centroid, the geometric characteristic of the composite set of printed scribe marks being a centroid formed by aggregating the respective centroids of the first and second sets of scribe marks as printed.

Still another aspect of the present invention relates to a reticle for use in a lithographic process. The reticle includes a design area, a first set of scribe marks located along a first side of the design area, and a second set of scribe marks located along a second side of the design area opposite the first side. The first and second sets of scribe marks have an associated symmetry relative to the design area such that, upon being printed onto adjacent fields of a wafer, the first set of printed scribe marks of one of the adjacent fields and the second set of printed scribe marks of another of the adjacent fields reticulate to form a composite set of printed scribe marks on the wafer, which is capable of being employed to substantially negate rotational error associated with the reticle employed in a lithographic printing process. Each of the first and second sets of scribe marks has a respective centroid. The geometric characteristic of the composite set of printed scribe marks being a centroid formed by aggregating respective centroids of the first and second sets of scribe marks as printed.

Yet another aspect of the present invention relates to a system for facilitating wafer alignment. The system includes a reticle including a design area, a first set of scribe marks located along a first side of the design area, and a second set of scribe marks located along a second side of the design area symmetric to the first set of scribe marks relative to the design area. The system includes at least one system for locating a composite set of scribe marks as printed on a surface layer of the wafer, the composite set of scribe marks being formed by aggregating the first set of scribe marks as printed on the surface layer of the wafer associated with a first field location and the second set of scribe marks as printed on the surface layer of the wafer associated with a second field location adjacent to the first field location. A processor controls general operations of the at least one system, the processor being configured to determine a geometric characteristic of the composite set of printed scribe marks. The processor employs the geometric characteristic to facilitate relative alignment of the wafer and the reticle. The geometric characteristic is a centroid of the composite set of printed scribe marks. Each of the first and second sets of scribe marks has a respective centroid, the geometric characteristic of the composite set of printed scribe marks being a centroid formed by aggregating the respective centroids of the first and second sets of scribe marks as printed.

The present disclosure also relates to a system for aligning a wafer. The system includes means for locating a composite set of scribe marks on a surface layer of the wafer, the composite set of scribe marks being formed from a first and second set of scribe marks printed on the surface layer of the wafer respectively associated with first and second adjacent fields, the first and second sets of printed scribe marks having an associated symmetry such that the composite set of scribe marks substantially negates reticle rotation error. The system also includes means for determining a geometric characteristic of the composite set of scribe marks, the geometric characteristic being a virtual alignment mark, and means for aligning the wafer using the virtual alignment mark as a reference.

To the accomplishment of the foregoing and related ends, the invention, then, comprises the features hereinafter fully described and particularly pointed out in the claims. The following description and the annexed drawings set forth in detail certain illustrative embodiments of the invention. These embodiments are indicative, however, of but a few of the various ways in which the principles of the invention may be employed. Other objects, advantages and novel features of the invention will become apparent from the following detailed description of the invention when considered in conjunction with the drawings.

### BRIEF DESCRIPTION OF THE DRAWINGS

Fig. 1 is a schematic illustration of a reticle having scribe marks in accordance with the present invention;
Fig. 2 is a schematic illustration of a wafer surface layer having design areas and scribe marks as printed from the reticle of Fig. 1 in accordance with the present invention;
Fig. 3a is an enlarged schematic illustration of a first horizontal set of scribe marks from Fig. 2 showing 35 a reference point thereof;
Fig. 3b is an enlarged schematic illustration of a second horizontal set of scribe marks from Fig. 2 showing a reference point thereof
Fig. 3c is a schematic illustration of a composite set of scribe marks formed of the first and second sets of scribe marks of Figs. 3a and 3b, wherein reticle rotation error resulted in each sets of scribe marks being shifted;
Fig. 3d is a schematic illustration of the composite set of scribe marks of Fig. 3c, illustrating a reference point of the composite set of scribe marks in accordance with the present invention;
Fig. 4a is an enlarged schematic illustration of a first vertical set of scribe marks from Fig. 2 showing a reference point thereof;
Fig. 4b is an enlarged schematic illustration of a second vertical set of scribe marks from Fig. 2 showing a reference point thereof;
Fig. 4c is a schematic illustration of a composite set of scribe marks formed of the first and second sets of scribe marks of Figs. 4a and 4b, wherein reticle rotation error resulted in each set of scribe marks being shifted;
Fig. 4d is a schematic illustration of the composite set of scribe marks of Fig. 4c, illustrating a reference point of the composite set of scribe marks in accordance with the present invention;
Fig. 5 is an enlarged view of part of Fig. 2 illustrating the location of a virtual alignment mark formed from the reference points of two sets of composite scribe marks in accordance with the present invention; and
Fig. 6 is a representative schematic illustration of a wafer alignment system in accordance with the present invention.

### MODES FOR CURRYING OUT THE INVENTION

The present invention will now be described with reference to the drawings, wherein like reference numerals are used to refer to like elements throughout.

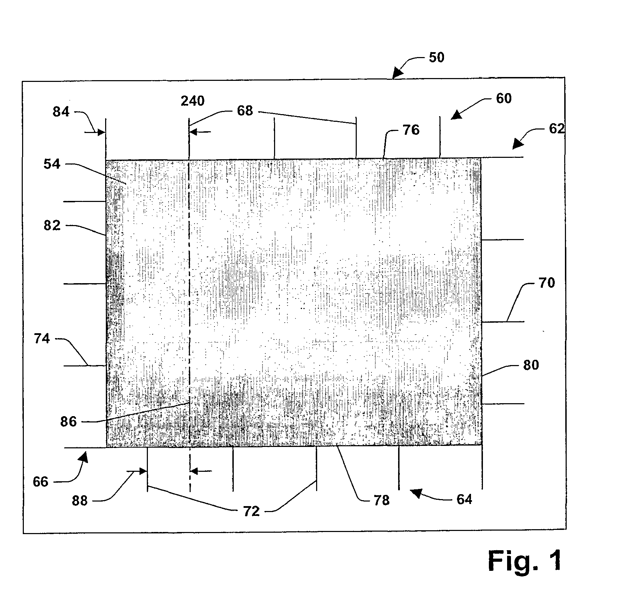

Fig. 1 is a representative schematic illustration of a reticle 50 in accordance with the present invention. The reticle 50 includes a design pattern 54 located at a substantially central region of the reticle 50. The design pattern 54 is typically imaged via an exposure source (such as light, x-rays, an electron beam or other electromagnetic energy) passing through the reticle 50 onto an exposure area of a wafer. The exposure source alters regions of a photoresist on the wafer exposed according to the design pattern 54 of the reticle 50. The reticle 50 also includes four sets 60, 62, 64, 66 of associated scribe marks 68, 70, 72, 74, respectively, located outside the design pattern to maximize design space utilization. Each respective set of scribe marks 60, 62, 64, 66 is disposed along an associated side 76, 78, 80, 82 of the design pattern 54. Selected sets of the scribe marks are employed to facilitate wafer alignment.

By way of example, opposed sets of scribe marks 60, 64 and 62, 66 are symmetric to each other relative to the design pattern 54, with the respective scribe marks 68, 72 and 70, 74 of each opposed set extending parallel to each other. Each set of scribe marks preferably has a predetermined pitch 84 (indicated only with respect to set 60 for ease of illustration). That is, each scribe mark 68, 72, 70, 74 is spaced apart from each adjacent scribe mark of its associated set 60, 64, 62, 66 by a distance defmed by the pitch length 84. In addition, each scribe mark is offset from a corresponding one of the scribe marks of the opposed set by about 2 the predetermined pitch length 84. The offset is illustrated in Fig. 1 by extending a line from the scribe mark 68 to a location substantially midway between an adjacent pair of scribe marks 72 of the opposed set of scribe marks 64. The offset between line 86 and an adjacent scribe mark 72, which offset is indicated at 88, is equal to about 2 the pitch 84. The symmetrical relationship and the offset between each opposed set of scribe marks 60, 64 and 62, 66 are utilized to form composite sets of scribe marks when printed at selected fields of a wafer.

For purposes of brevity and ease of illustration, a relatively small number of scribe marks (five marks along each horizontal side and four marks along each vertical side) are shown along each side 76, 78, 80, 82 of the design pattern 54. It will be appreciated that any number of scribe marks (greater or lesser than shown) may be implemented in accordance with the present invention. Additionally, while the scribe marks of each opposed set are illustrated as substantially parallel lines, it will be appreciated that other configurations and relative arrangements of scribe marks could be used.

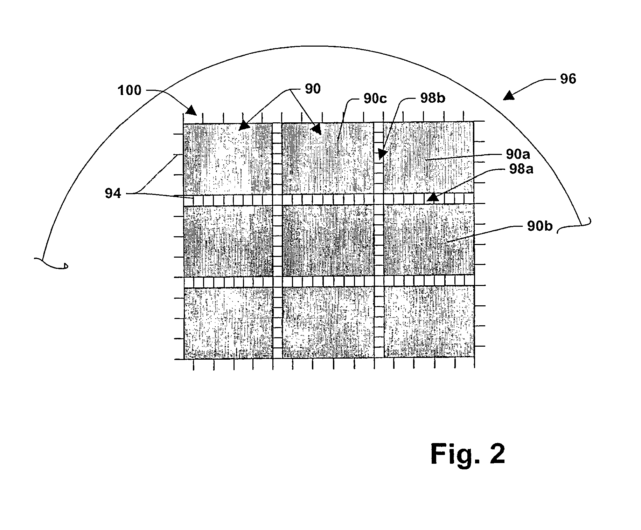

Fig. 2 is a schematic representation of several design patterns 90 and associated scribe marks 94 printed on a surface layer of a wafer 96 at selected fields. Each printed design pattern 90 corresponds to the design pattern 54 from the reticle 50 (Fig. 1) as printed during a photolithography process. The scribe marks 94 associated with adjacent pairs of printed design patterns 90 reticulate (i.e., interleave or mesh) to form composite sets of scribe marks 98. In particular, each composite set of scribe marks 98 comprises alternating scribe marks from each adjacent constituent set of scribe marks. That is, each composite set of scribe marks 98 is an aggregate of two adjacent sets of scribe marks as printed with an adjacent pair of design patterns.

For example, the composite set of scribe marks 98a is an aggregate of the bottom set of scribe marks associated with design pattern 90a and the top set of scribe marks associated with design pattern 90b (top and bottom being used to describe relative positions between design patterns for ease of understanding). Similarly, the composite set of scribe marks 98b is an aggregate of the left set of scribe marks associated with design pattern 90a and the right set of scribe marks associated with design pattern 90c (left and right being used to describe relative positions between design patterns for ease of understanding). Each composite set of printed scribe marks 98 has a pitch defined by the aggregation of scribe marks that form the respective composite set. In contrast, each set of scribe marks 100 printed at the perimeter of the wafer 96 (i.e., nearest the edge of the wafer 96) have twice the pitch of each composite set of scribe marks 98, since its scribe marks only include those from a single set of scribe marks.

Reticle rotation errors and/or lens magnification errors which typically manifest in sets of scribe marks being printed at locations on the wafer surface level (a particular photoresist layer) different from desired locations are substantially negated by the composite sets of scribe marks 98. As stated above, this is the result of the symmetry and offset of opposed sets of scribe marks 60, 64 and 62, 66 of the reticle 50 (Fig. 1). Although reticle rotation and/or lens magnification errors manifest in each printed set of scribe marks individually, the errors are substantially negated with respect to each composite set of scribe marks. By using one or more selected composite sets of scribe marks to define a corresponding reference mark for wafer alignment, overlay errors due to reticle rotation and/or lens magnification/demagnification are substantially mitigated.

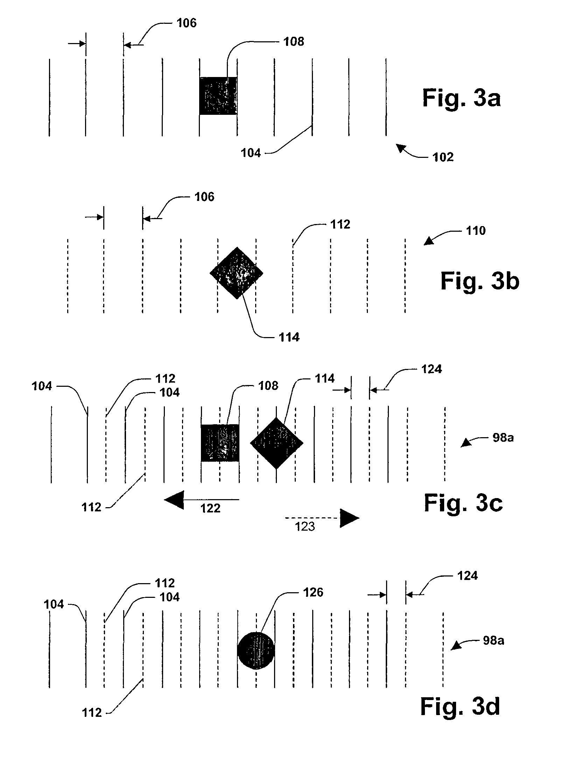

Fig. 3a illustrates, for example, an enlarged view of a set of printed scribe marks 102, such as extending from the bottom side of a printed design pattern (90a of Fig. 2). The set 102 includes individual scribe marks 104 having a predetermined pitch, indicated at 106. The set of scribe marks 102 has a geometric reference point (e.g., a centroid position) indicated by a square 108, which may be geometrically determined by a stepper system (not shown). The position of the geometric reference point 108 varies as a function of the location and configuration of the scribe lines 104.

Fig. 3b illustrates another set of printed scribe marks 110 of an adjacent field, for example, extending from the top side of a printed design pattern (90b of Fig. 2). For purposes of ease of illustration, individual scribe marks 112 of set 110 are shown as dashed lines to distinguish from the solid scribe marks 104 of Fig. 3a. The set of scribe marks 110 has a geometric reference point (e.g., a centroid), as indicated by diamond 114, which varies as a function of scribe marks 112. The set 110 has the same predetermined pitch 106 as the set 102 of Fig. 3a. Each scribe mark 112 is offset from a corresponding scribe mark 104 of the other set 102 (Fig. 3a) by about 2 the predetermined pitch 106. The offset between the scribe marks 104 and 112 is imparted during printing of the adjacent design patterns 90a and 90b with the reticle 50 (Fig. 1). The set of printed scribe marks 102 of Fig. 3a, for example, corresponds to scribe marks printed from set 64 of the reticle associated with a first design pattern 90a (Figs. 1 and 2) and the set of printed scribe marks 110 of Fig. 3b correspond to scribe marks printed from the set 60 of the reticle associated with a second design pattern 90b (Figs. 1 and 2).

Fig. 3c illustrates the composite set of printed scribe marks 98a which is an aggregate of sets 102, 110 (Figs. 3a, 3b). The relative orientation (offset) between the scribe marks 104, 112 of each respective set 102, 110 results in the composite set of scribe marks 98a being formed of alternating scribe marks 104, 112 from each constituent set. This results in the composite set of scribe marks 98a having a pitch 124 that is typically about 2 the pitch 106 of its constituent sets. Arrows 122, 123 illustrate the direction that each respective constituent set of scribe marks 102, 110 might shift when printed due to reticle rotation error. The centroid 108, 114 of each respective set 102, 110 also shifts in the direction of the respective arrows 122, 123, as each centroid varies as a function of the position of the respective scribe mark 104, 112. It will be appreciated that the amount of shifting in each direction 122, 123 has been exaggerated for ease of illustration. The amount of shifting usually will be substantially less than that shown. It will be appreciated that, in addition to such shifting, each set of scribe marks 102, 110 might also experience a slight angular shift due to reticle rotation error. Such angular rotation of each set of scribe marks has been omitted from Figs. 3c and 3d for purposes of ease of illustration.

Because each set of scribe marks 102, 112 is formed from scribe marks which are offset from each other and located symmetrically on opposite sides (e.g., the top and bottom sides) of the reticle design pattern 54 (Fig. 1), the effects of reticle rotational error for each set of scribe marks 102, 112 occur in substantially opposite directions and equal magnitudes. As a result, the composite set of scribe marks 98a substantially negates the effects of such rotation. Referring to Fig. 3d, the composite set of scribe marks 98a has a centroid 126, which is the aggregate of the centroids 108, 114 of its respective constituent sets 102, 110. Because each of the centroids 108, 114 shifts in opposite directions in response to reticle rotation error, the aggregation thereof (as it exists in centroid 126) substantially negates such error. Therefore, the composite centroid 126 provides a point of reference for wafer alignment which is substantially free of errors manifesting from reticle rotation and/or lens magnification.

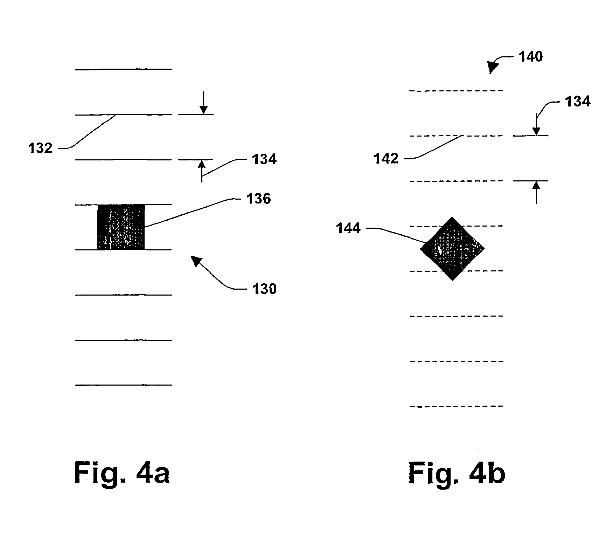

Figs. 4a-4d illustrate formation of another composite set of scribe marks from two different sets of printed scribe marks, such as, for example, the composite set of scribe marks 98b extending vertically between adjacent printed design patterns 90a and 90c (Fig. 2). The formation of the composite set 98b is substantially identical to that of Figs. 3a-3d. Briefly stated, Fig. 4a illustrates an enlarged view of a set of printed scribe marks 130, suitably formed of scribe marks 132 extending from the left side of a printed design pattern 90a (Fig. 2). The set of scribe marks 130 has a predetermined pitch, indicated at 134, which may be the same as the pitch 106. The set of scribe marks 130 also has a geometric reference point (e.g., a centroid position), indicated by a square 136, which varies as a function of the scribe marks 132.

Fig. 4b illustrates another set of printed scribe marks 140 that includes scribe marks 142 which, for example, extend from the right side of an adjacent printed design pattern 90c (Fig. 2). While, for purposes of ease illustration, individual scribe marks 142 are shown as dashed lines, it will be appreciated that both sets 130 and 140 typically (although not necessarily) are solid lines. The set of scribe marks 140 has the same predetermined pitch 134 as the set 130 of Fig. 4a. Preferably, each scribe mark 142 is printed at an offset from relative to a corresponding scribe mark 104 of the other set 130 (Fig. 3a), such as being offset by 2 the pitch 134. The offset results from employing the reticle 50 (Fig. 1) configured with opposed sets of scribe marks 62 and 66 having an associated symmetry and a selected offset, as previously described with respect to Fig. 1. The set of scribe marks 140 has a geometric reference point (e.g., centroid position), indicated by diamond 144, which varies as a function of the constituent scribe marks 142.

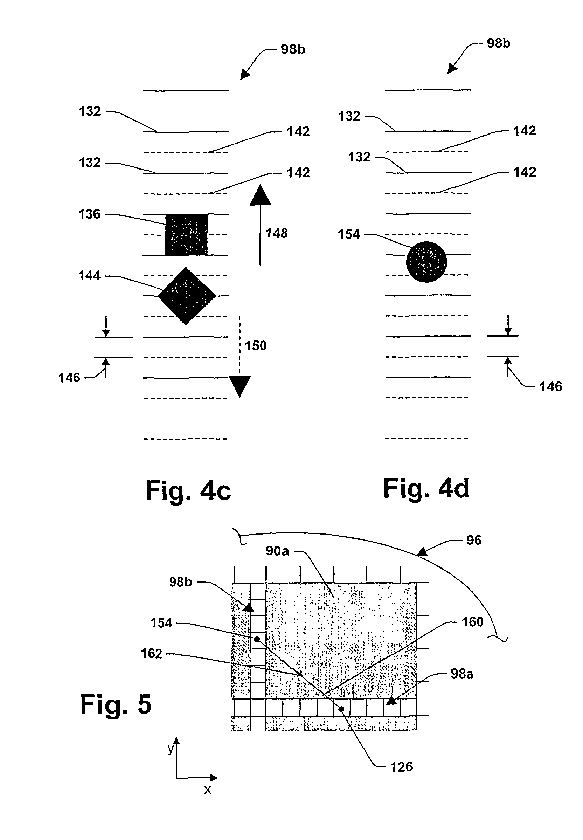

Fig. 4c is a schematic illustration of the composite set of scribe marks 98b formed by aggregating the sets of scribe marks 130 and 140. The symmetric relationship and offset between the scribe marks 132, 142 of each respective set 130, 140 result in the scribe marks 132, 142 reticulating (i.e., interleaving or meshing) to form the composite set of scribe marks 98b, which includes alternating scribe marks 132 and 142 from each respective set. The offset between each set of scribe marks 130, 140 provides the composite set of scribe marks 98b with a pitch 146 that is about 2 the pitch 134 of each of its constituent sets. Arrows 148, 150 have been added to illustrate the direction that each respective constituent set of scribe marks 130, 140 may shift due to reticle rotation error. The amount of shifting in each direction again has been exaggerated for ease of illustration. It will be appreciated that each centroid 136, 144 shifts in the direction of the respective arrows 148, 150 commensurate with such rotation error. Under ideal operating conditions, the offset between centroids should be equal to the distance (offset) between an adjacent pair of printed scribe marks (e.g., about 2 pitch of either set when having equal pitches).

Fig. 4d illustrates a centroid 154 of the composite set of scribe marks 98b. The centroid 154 may be determined by aggregating the centroids 136, 144 of each constituent set 130, 140, such as the midpoint between the centroids. Alternatively, the centroid or another geometric characteristic of the composite set of scribe marks 98b may be calculated from the location of the individual scribe marks 132 and 142 that form the composite set of scribe marks 98b.

As stated above, the composite set of scribe marks 98b substantially negates the effects of reticle rotation error. In particular, reticle rotation error causes each set of scribe marks 130, 140 to shift in substantially equal amounts and in opposite directions due the symmetrical relationship and offset which is provided by the corresponding sets of scribe marks of the reticle 50. As a result, the centroid 154 of the composite set of scribe marks 98b compensates for the shifting of each constituent set of scribe marks 130, 140, such that the effects of reticle rotation error are substantially negated. Thus, composite centroid 154 provides a point of reference for wafer alignment which is substantially free of errors manifesting from reticle rotation and lens magnification.

Fig. 5 is an enlarged view of part of the wafer 96 of Fig. 2 to illustrate the composite sets of scribe marks 98a and 98b located along adjacent sides of the design pattern 90a. Each composite set of scribe marks 98a, 98b has a respective centroid 126, 154. As stated above, the centroid 126, 154 of each composite set of scribe marks 98a, 98b mitigates reticle rotation error manifested by shifting the sets of scribe marks 102, 110 and 130, 140 (Figs. 3a-4d) that form each respective composite set of scribe marks 98a, 98b. Accordingly, the centroids 126 and 154 may be used as reference points for determining a virtual alignment mark to facilitate relative alignment between the wafer and reticle.

By way of example, a line 160 is drawn to extend between the centroids 126 and 154. A midpoint 162 along the line 160 between die centroids 126 and 154 is employed as a virtual alignment mark 162. The centroid 122 mitigates reticle rotation error in the x-direction and centroid 154 mitigates reticle rotation error in the y-direction. Advantageously, the virtual alignment mark 162 determined from centroids 122 and 154 provides a reference point that is substantially free from the effects of reticle rotation error that occurs in both the x-direction and the y-direction. As a result, the virtual alignment mark 162 may be employed to facilitate mitigation of overlay errors due to reticle rotation and/or lens magnification/demagnification. In order to further mitigate such errors, more than one virtual mark may be determined from selected composite sets of scribe marks in accordance with the present invention.

While for purposes of explanation, the virtual alignment mark has been determined as a function of centroids 126 and 154 located along adjacent sides of a common design pattern 90a, it will be appreciated that a centroid (or other geometric characteristic) could be determined for any composite set of scribe marks associated with any design pattern on the wafer 96. In addition, one or more reference points of any composite set of scribe marks, such as a centroid, could be employed as a virtual alignment mark to facilitate relative alignment between the wafer 96 and reticle 50.

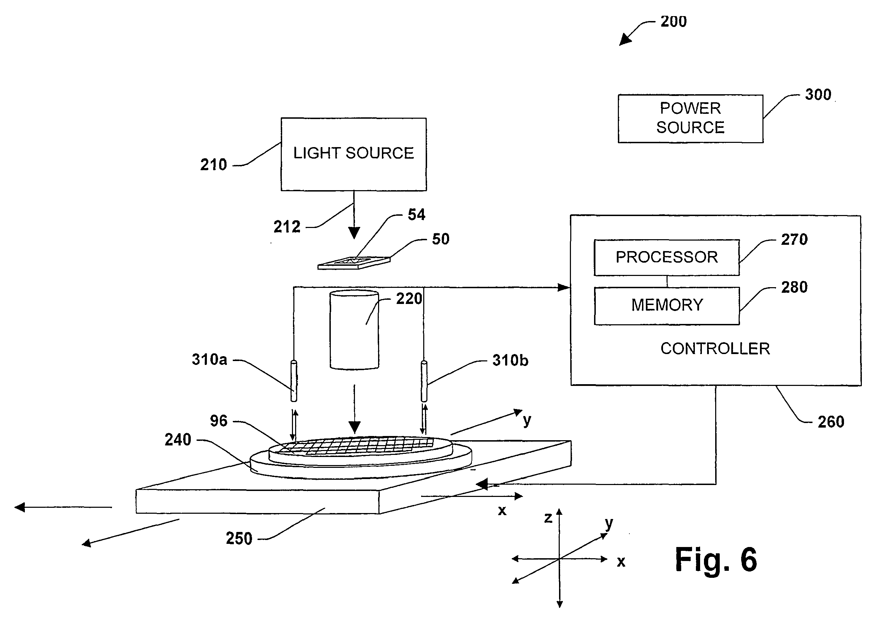

Fig. 6 is a representative system 200 for wafer alignment in accordance with the present invention. The system 200 includes the reticle 50 with the design pattern 54. A light source 210 projects light 212 through the reticle 50 to so as to project the design pattern 54 onto the wafer 90. The light 212 from the light source 210 passes through the reticle 50 and through the optical axis of a projection lens system 220. The projection lens system 220 projects the design pattern 54 of the reticle 50 onto the wafer 96 while in most cases substantially reducing the imaged design pattern. It is to be appreciated that reflection-type systems, scanning systems and other suitable systems may be employed in carrying out the present invention.

A wafer holder 240 vacuum-adsorbs the wafer 96 and is provided for slight rotation relative to a stage 250 two-dimensionally moveable in an x-direction and y-direction. The stage 250 and wafer holder 240 are controlled by a controller 260. The controller 260 effects rotation of the wafer holder 240 and movement of the stage 250 (via a plurality of motors (not shown)) for wafer alignment and positioning. The controller 260 includes a processor 270 which is programmed to control and operate the various components within the system 200 in order to carry out the various functions described herein. The manner in which the processor 270 can be programmed to cany out the functions relating to the present invention will be readily apparent to those having ordinary skill in the art based on the description provided herein.

A memory 280 which is operatively coupled to the processor 270 is also included in the controller 260 and serves to store program code executed by the processor 270 for carrying out operating functions of the system 200 as described herein. The memory 280 includes, for example, read only memory (ROM) and random access memory (RAM). The RAM is the main memory into which the operating system and application programs are loaded. The memory 280 also serves as a storage medium for temporarily storing information such as reticle position, wafer position, reticle coordinate tables, wafer coordinate tables, alignment mark information, printed alignment mark information, virtual aligmnent mark information, programs for determining virtual alignment mark locations and other data which may be employed in carrying out the present invention. For mass data storage, the memory 280 may also include a hard disk drive (e.g., 50 Gigabyte hard drive).

A power source 300 provides operating power to the system 200. Any suitable power source (e.g., battery, line power) may be employed to implement the present invention.

In one specific case, the system 200 further includes off-axis type wafer alignment microscopes 310a and 310b (collectively referred to by reference number 310). The microscopes 310 have optic axes parallel to the optic axis of the projection system 220 and image on the wafer 96 band-like laser light spots (not shown), for example. The band-like laser spots are light of a wavelength which does not activate the photosensitive agent (photoresist) on the wafer 96. Each microscope 310 has a photo-element (not shown) receiving scattered light and diffracted light from the scribe marks printed on the wafer surface (photoresist). The microscopes 310 also include systems for synchronizing and rectifying the photoelectric signal output by the photo-elements, respectively, at the vibration period of the light spot(s) and output an alignment signal corresponding to alignment mark deviation relative to the center of vibration of the light spot(s). It is to be appreciated that the wafer alignment mark positioning systems are evolving rapidly and any suitable positioning system (e.g., through the lens system) may be employed to carry out the present invention and is intended to fall within the scope of the hereto appended claims.

The system 200 employs the microscopes 310 to facilitate finding and mapping the locations of the composite sets of scribe marks 98a and 98b as printed on the surface layer of the wafer 96. Once the location of each composite set of scribe marks 98a, 98b has been mapped, the processor 270 can determine a geometric characteristic (e.g., centroid position) of each respective composite set of scribe marks. The geometric reference point varies as a function of the location and configuration of scribe marks that form each respective composite set. The processor 270 then determines the midpoint of the respective centroids in order to map the virtual aligmnent mark 162. The processor 210 employs the victual alignment mark 162 as a reference for wafer alignment. It will be appreciated that the centroids themselves may be used as virtual marks in addition to, or as an alternative to the virtual alignment mark 162 described above.

Wafer alignment systems are well known in the art, and therefore it is to be appreciated that conventional aspects of the system 200 are described herein at a high level or omitted for sake of brevity. One skilled in the art could readily construct a wafer alignment system in accordance with the present invention based on the teachings herein.

It is to be appreciated that a number of geometric relationships exist which the processor 270 may employ in determining the location of a virtual mark, such as from composite sets of scribe marks 98a and 98b, from their centroid positions 126 and 154, respectively, and/or from any other geometric characteristic of one or both composite set of scribe marks. The use of any and all such relationships is intended to fall within the scope of the present invention as defined by the hereto appended claims. The geometric relationship between the composite sets of scribe marks 98a, 98b and/or centroids 126, 154 may be employed by the processor 270 to map a virtual alignment mark in accordance with the present invention so as to facilitate wafer alignment and mitigate overlay error due to reticle rotation errors and/or lens magnification errors. Based on the above description, one skilled in the art could easily program the processor 270 of system 200 to determine a virtual alignment mark in accordance with this embodiment of the present invention.

Since the virtual alignment marks afford for alignment of the wafer with respect to the respective reticle of each virtual alignment mark, reticle rotation errors and/or magnification errors are mitigated on a layer by layer basis, and on a multi-layer basis as well since overlay errors with respect to a given layer will not manifest in compounded overlay errors in subsequently formed layers as sometimes results conventionally.

What has been described above are preferred embodiments of the present invention. It is, of course, not possible to describe every conceivable combination of components or methodologies for purposes of describing the present invention, but one of ordinary skill in the art will recognize that many further combinations and permutations of the present invention are possible. Accordingly, the present invention is intended to embrace all such alterations, modifications and variations that fall within the scope of the appended claims.

### Industrial Applicability

The present invention has applicability in the field of semiconductor processing.

## Claims

1. A method for determining a reference point on a wafer (96), comprising:
forming a composite set of scribe marks (98a,98b) from a first and second set of scribe marks (102,110,130,140), wherein the composite set of scribe marks (98a,98b) has a geometric characteristic which is capable of being employed as the reference point to substantially negate rotational error associated with a reticle (50) employed in a lithographic printing process, and
**characterized in that** each of the first and second sets of scribe marks (102,110, 130,140) has a respective centroid (108,114,136,144), the geometric characteristic of the composite set of scribe marks (98a,98b) being a centroid (126,154) formed by aggregating the respective centroids (108,114,136,144) of the first and second sets of scribe marks (102,110,130,140) as printed on a surface layer of the wafer (96).

2. The method of claim 1, wherein each of the first and second sets of scribe marks (102,110,130,140) is located between first and second adjacent design patterns (90) printed on the surface layer of the wafer (96).

3. The method of claim 2, wherein the step of forming further includes printing the first set of scribe marks (102,130) on a surface layer of the wafer (96) associated with the first printed design pattern and printing the second set of scribe marks (110,140) on the surface layer of the wafer (96) associated with the second printed design pattern, such that the first and second sets of printed scribe marks (102,110,130,140) reticulate to form the composite set of scribe marks (98a,98b).

4. The method of claim 3, wherein the composite set of scribe marks is a first composite set of scribe marks (98a), the method further including the steps of forming a second composite set of scribe marks (98b) from a third and fourth set of scribe marks (130,140), the second composite set of scribe marks (98b) having a geometric characteristic being another centroid formed by aggregating the respective centroids of the third and fourth set of scribe marks (130,140), the geometric characteristics of the first and second composite sets of scribe marks (98a,98b) respectively capable of being employed to substantially mitigate reticle rotational error.

5. The method of claim 4, further including the steps of determining a virtual reference mark (162) based on respective geometric characteristics (126,154) of the first and second composite sets of scribe marks (98a,98b) and using the virtual reference mark (162) to facilitate relative alignment between the wafer (96) and reticle (50).

6. A method for facilitating wafer alignment, comprising the steps of:
using a reticle (50), including:
a design area (54);
a first set of scribe marks (60,62); and
a second set of scribe marks (64,66) symmetric to the first set of scribe marks (60,62) relative to the design area (54);
printing the first and second sets of scribe marks (60,62,64,66) on a surface layer of a wafer (96) associated with a first field location; and
printing the first and second sets of scribe marks (60,62,64,66) on the surface layer of the wafer (96) associated with a second field location adjacent to the first field location such that the first set of printed scribe marks of the first field location and the second set of printed scribe marks of the second field location form a composite set of printed scribe marks (98a,98b) which is capable of being employed to substantially negate rotational error associated with the reticle (50) employed in a lithographic printing process, **characterized in that** each of the first and second sets of scribe marks (60,62,64,66) has a respective centroid (108,114, 136,144), the geometric characteristic of the composite set of printed scribe marks (98a,98b) being a centroid (126,154) formed by aggregating the respective centroids (108,114,136,144) of the first and second sets of scribe marks (60,62,64,66) as printed.

7. A reticle (50) for use in a lithographic process, comprising:
a design area (54);
a first set of scribe marks (60,62) located along a first side of the design area; and
a second set of scribe marks (64,66) located along a second side of the design area opposite the first side, the first and second sets of scribe marks (60,62,64,66) having an associated symmetry relative to the design area (54) such that, upon being printed onto adjacent fields of a wafer, the first set of printed scribe marks of one of the adjacent fields and the second set of printed scribe marks of another of the adjacent fields reticulate to form a composite set of printed scribe marks (98a,98b) on the wafer which is capable of being employed to substantially negate rotational error associated with employing the reticle in a lithographic printing process;
**characterized in that** each of the first and second sets of scribe marks (60,62,64,66) has a respective centroid (108,114,136,144), the geometric characteristic of the composite set of printed scribe marks (98a,98b) being a centroid (126,154) formed by aggregating the respective centroids (108,114,136,144) of the first and second sets of scribe marks (60,62,64,66) as printed.

8. A system for facilitating wafer alignment, comprising:
a reticle (50), including:
a design area (54);
a first set of scribe marks (60,62) located along a first side of the design area; and
a second set of scribe marks (64,66) located along a second side of the design area symmetric to the first set of scribe marks relative to the design area;
at least one system (200) for locating a composite set of scribe marks as printed on a surface layer of the wafer, the composite set of scribe marks being formed by aggregating the first set of scribe marks as printed on the surface layer of the wafer associated with a first field location and the second set of scribe marks as printed on the surface layer of the wafer associated with a second field location adjacent to the first field location; and
a processor (270) for controlling general operations of the at least one system (200), the processor (270) being configured to determine a geometric characteristic of the composite set of printed scribe marks (98a,98b), the processor (270) employing the geometric characteristic to facilitate relative alignment of the wafer (96) and the reticle (50); wherein the geometric characteristic is a centroid of the composite set of printed scribe marks (98a,98b), **characterized in that** each of the first and second sets of scribe marks (60,62,64,66) has a respective centroid (108,114,136,144), the geometric characteristic of the composite set of printed scribe marks (98a,98b) being a centroid (126,154) formed by aggregating the respective centroids (108,114,136,144) of the first and second sets of scribe marks (60,62,64,66) as printed.

9. The system of claim 8, further comprising:
means for locating a composite set of scribe marks on a surface layer of the wafer, the composite set of scribe marks being formed from a first and second set of scribe marks printed on the surface layer of the wafer respectively associated with first and second adjacent fields, the first and second sets of printed scribe marks having an associated symmetry such that the composite set of scribe marks substantially negates reticle rotation error;
means for determining the geometric reference characteristic of the composite set of scribe marks, the geometric reference characteristic being a virtual alignment mark; and
means for aligning the wafer using the virtual alignment mark as a reference.

## Patentansprüche

1. Verfahren zum Bestimmen eines Referenzpunktes auf einem Wafer (96), umfassend folgende Schritte:
- Bilden eines kombinierten Satzes Anreißmarkierungen (98a, 98b) aus einem ersten und zweiten Satz Anreißmarkierungen (102, 110, 130, 140), wobei der kombinierte Satz Anreißmarkierungen (98a, 98b) eine geometrische Charakteristik aufweist, die als Referenzpunkt verwendet werden kann, um einen Rotationsfehler im Wesentlichen aufzuheben, der mit einer Strichplatte (50) verknüpft ist, die bei einem lithographischen Druckprozess verwendet wird, und
**dadurch gekennzeichnet, dass** jeder der ersten und zweiten Sätze Anreißmarkierungen (102, 110, 130, 140) einen jeweiligen Schwerpunkt (108, 114, 136, 144) aufweist, wobei die geometrische Charakteristik des kombinierten Satzes Anreißmarkierungen (98a, 98b) ein Schwerpunkt (126, 154) ist, der dadurch gebildet wird, dass die jeweiligen Schwerpunkte (108, 114, 136, 144) der ersten und zweiten Sätze Anreißmarkierungen (102, 110, 130, 140) zusammengefasst werden, wenn sie auf eine Oberflächenschicht des Wafers (96) gedruckt werden.

2. Verfahren nach Anspruch 1, wobei sich jeder der ersten und zweiten Sätze Anreißmarkierungen (102, 110, 130, 140) zwischen ersten und zweiten angrenzenden Entwurfsmustern (90) befindet, die auf der Oberflächenschicht des Wafers (96) gedruckt sind.

3. Verfahren nach Anspruch 2, wobei der Schritt des Bildens ferner das Drucken des ersten Satzes Anreißmarkierungen (102, 130) auf eine Oberflächenschicht des Wafers (96), die mit dem ersten gedruckten Entwurfsmuster verknüpft ist, und das Drucken des zweiten Satzes Anreißmarkierungen (110, 140) auf die Oberflächenschicht des Wafers (96), die mit dem zweiten gedruckten Entwurfsmuster verknüpft ist, umfasst, so dass die ersten und zweiten Sätze gedruckter Anreißmarkierungen (102, 110, 130, 140) sich netzförmig ausdehnen, um den kombinierten Satz Anreißmarkierungen (98a, 98b) zu bilden.

4. Verfahren nach Anspruch 3, wobei der kombinierte Satz Anreißmarkierungen ein erster kombinierter Satz Anreißmarkierungen (98a) ist, wobei das Verfahren ferner den Schritt des Bildens eines zweiten kombinierten Satzes Anreißmarkierungen (98b) aus einem dritten und vierten Satz Anreißmarkierungen (130, 140) umfasst, wobei der zweite kombinierte Satz Anreißmarkierungen (98b) eine geometrische Charakteristik aufweist, die ein anderer Schwerpunkt ist, der dadurch gebildet wird, dass die jeweiligen Schwerpunkte der dritten und vierten Sätze Anreißmarkierungen (130, 140) zusammengefasst werden, wobei die geometrischen Charakteristiken der ersten und zweiten kombinierten Sätze Anreißmarkierungen (98a, 98b) jeweils verwendet werden können, um den Strichplatten-Rotationsfehler im Wesentlichen zu mindern.

5. Verfahren nach Anspruch 4, ferner umfassend die Schritte des Bestimmens einer virtuellen Referenzmarkierung (162) basierend auf jeweiligen geometrischen Charakteristiken (126, 154) der ersten und zweiten kombinierten Sätze Anreißmarkierungen (98a, 98b) und des Verwendens der virtuellen Referenzmarkierung (162), um eine relative Ausrichtung zwischen dem Wafer (96) und der Strichplatte (50) zu erleichtern.

6. Verfahren zum Erleichtern einer Wafer-Ausrichtung, umfassend folgende Schritte:
- Verwenden einer Strichplatte (50), die Folgendes umfasst:
eine Entwurfsfläche (54);
einen ersten Satz Anreißmarkierungen (60, 62); und
einen zweiten Satz Anreißmarkierungen (64, 66), die zu dem ersten Satz Anreißmarkierungen (60, 62) im Verhältnis zu der Entwurfsfläche (54) symmetrisch sind;
- Drucken der ersten und zweiten Sätze Anreißmarkierungen (60, 62, 64, 66) auf einer Oberflächenschicht eines Wafers (96), die mit einer ersten Feldposition verknüpft ist; und
- Drucken der ersten und zweiten Sätze Anreißmarkierungen (60, 62, 64, 66) auf der Oberflächenschicht des Wafers (96), die mit einer zweiten Feldposition neben der ersten Feldposition verknüpft ist, so dass der erste Satz gedruckter Anreißmarkierungen der ersten Feldposition und der zweite Satz gedruckter Anreißmarkierungen der zweiten Feldposition einen kombinierten Satz gedruckter Anreißmarkierungen (98a, 98b) bilden, der verwendet werden kann, um einen Rotationsfehler im Wesentlichen aufzuheben, der mit der Strichplatte (50) verknüpft ist, die bei einem lithographischen Druckprozess verwendet wird,
**dadurch gekennzeichnet, dass** jeder der ersten und zweiten Sätze Anreißmarkierungen (60, 62, 64, 66) einen jeweilige Schwerpunkt (108, 114, 136, 144) aufweist, wobei die geometrische Charakteristik des kombinierten Satzes gedruckter Anreißmarkierungen (98a, 98b) ein Schwerpunkt (126, 154) ist, der dadurch gebildet wird, dass die jeweiligen Schwerpunkte (108, 114, 136, 144) der ersten und zweiten Sätze Anreißmarkierungen (60, 62, 64, 66) wie gedruckt zusammengefasst werden.

7. Strichplatte (50) zur Verwendung bei einem lithographischen Prozess, umfassend:
eine Entwurfsfläche (54);
einen ersten Satz Anreißmarkierungen (60, 62), der sich entlang einer ersten Seite der Entwurfsfläche befindet; und
einen zweiten Satz Anreißmarkierungen (64, 66), der sich entlang einer zweiten Seite der Entwurfsfläche gegenüber der ersten Seite befindet, wobei die ersten und zweiten Sätze Anreißmarkierungen (60, 62, 64, 66) eine verknüpfte Symmetrie mit Bezug auf die Entwurfsfläche (54) aufweisen, so dass sich nach dem Drucken auf angrenzende Felder eines Wafers der erste Satz gedruckter Anreißmarkierungen eines der angrenzenden Felder und der zweite Satz gedruckter Anreißmarkierungen eines anderen der angrenzenden Felder netzförmig ausdehnen, um einen kombinierten Satz gedruckter der erste Satz Anreißmarkierungen (98a, 98b) auf dem Wafer zu bilden, der verwendet werden kann, um einen Rotationsfehler im Wesentlichen aufzuheben, der mit der Verwendung der Strichplatte in einem lithographischen Druckprozess verknüpft ist;
**dadurch gekennzeichnet, dass** jeder der ersten und zweiten Sätze Anreißmarkierungen (60, 62, 64, 66) einen jeweiligen Schwerpunkt (108, 114, 136, 144) aufweist, wobei die geometrische Charakteristik des kombinierten Satzes gedruckter Anreißmarkierungen (98a, 98b) ein Schwerpunkt (126, 154) ist, der dadurch gebildet wird, dass die jeweiligen Schwerpunkte (108, 114, 136, 144) der ersten und zweiten Sätze Anreißmarkierungen (60, 62, 64, 66) wie gedruckt zusammengefasst werden.

8. System zum Erleichtern der Wafer-Ausrichtung, umfassend:
- eine Strichplatte (50), umfassend:
eine Entwurfsfläche (54);
einen ersten Satz Anreißmarkierungen (60, 62), der sich entlang einer ersten Seite der Entwurfsfläche befindet; und
einen zweiten Satz Anreißmarkierungen (64, 66), der sich entlang einer zweiten Seite der Entwurfsfläche befindet, die zu dem ersten Satz Anreißmarkierungen mit Bezug auf die Entwurfsfläche symmetrisch ist;
mindestens ein System (200) zum Lokalisieren eines kombinierten Satzes Anreißmarkierungen wie auf einer Oberflächenschicht des Wafers gedruckt, wobei der kombinierte Satz Anreißmarkierungen dadurch gebildet wird, dass der erste Satz Anreißmarkierungen wie auf die Oberflächenschicht des Wafers gedruckt, die mit einer ersten Feldposition verknüpft ist, und der zweite Satz Anreißmarkierungen wie auf die Oberflächenschicht des Wafers gedruckt, die mit einer zweiten Feldposition neben der ersten Feldposition verknüpft ist, zusammengefasst werden; und
einen Prozessor (270) zum Steuern des allgemeinen Betriebs des mindestens einen Systems (200), wobei der Prozessor (270) konfiguriert ist, um eine geometrische Charakteristik des kombinierten Satzes gedruckter Anreißmarkierungen (98a, 98b) zu bestimmen, wobei der Prozessor (270) die geometrische Charakteristik verwendet, um eine relative Ausrichtung des Wafers (96) und der Strichplatte (50) zu erleichtern; wobei die geometrische Charakteristik ein Schwerpunkt des kombinierten Satzes gedruckter Anreißmarkierungen (98a, 98b) ist, **dadurch gekennzeichnet, dass** jeder der ersten und zweiten Sätze Anreißmarkierungen (60, 62, 64, 66) einen jeweiligen Schwerpunkt (108, 114, 136, 144) aufweist, wobei die geometrische Charakteristik des kombinierten Satzes gedruckter Anreißmarkierungen (98a, 98b) ein Schwerpunkt (126, 154) ist, der dadurch gebildet wird, dass die jeweiligen Schwerpunkte (108, 114, 136, 144) der ersten und zweiten Sätze Anreißmarkierungen (60, 62, 64, 66) wie gedruckt zusammengefasst werden.

9. System nach Anspruch 8, ferner umfassend:
- Mittel zum Lokalisieren eines kombinierten Satzes Anreißmarkierungen auf einer Oberflächenschicht des Wafers, wobei der kombinierte Satz Anreißmarkierungen aus einem ersten und zweiten Satz Anreißmarkierungen gebildet wird, die auf der Oberflächenschicht des Wafers gedruckt sind, die jeweils mit ersten und zweiten angrenzenden Feldern verknüpft ist, wobei die ersten und zweiten Sätze gedruckter Anreißmarkierungen eine verknüpfte Symmetrie aufweisen, so dass der kombinierte Satz Anreißmarkierungen einen Strichplatten-Rotationsfehler im Wesentlichen aufhebt;
- Mittel zum Bestimmen der geometrischen Referenzcharakteristik des kombinierten Satzes Anreißmarkierungen, wobei die geometrische Referenzcharakteristik eine virtuelle Ausrichtungsmarkierung ist; und
- Mittel zum Ausrichten des Wafers unter Verwendung der virtuellen Ausrichtungsmarkierung als Referenz.

## Revendications

1. Procédé de détermination d'un point de référence sur une tranche (96), comprenant :
la formation d'un ensemble composite de marques tracées (98a, 98b) à partir d'un premier et d'un deuxième ensemble de marques tracées (102, 110, 130, 140), dans lequel l'ensemble composite de marques tracées (98a, 98b) a une caractéristique géométrique qu'on est à même d'employer en tant que point de référence pour sensiblement annuler l'erreur de rotation associée à un réticule (50) employé lors d'un procédé d'impression lithographique, et
**caractérisé en ce que** chacune des premier et deuxième ensembles de marques tracées (102, 110, 130, 140) présente un centroïde respectif (108, 114, 136, 144), la caractéristique géométrique de l'ensemble composite de marques tracées (98a, 98b) étant un centroïde (126, 154) formé par agrégation des centroïdes respectifs (108, 114, 136, 144) des premier et deuxième ensembles de marques tracées (102, 110, 130, 140) tels qu'ils sont imprimés sur une couche de surface de la tranche (96).

2. Procédé selon la revendication 1, dans lequel chacun des premier et deuxième ensembles de marques tracées (102, 110, 130, 140) se trouve entre de premier et deuxième motifs adjacents de design (90) imprimés sur la couche de surface de la tranche (96).

3. Procédé selon la revendication 2, dans lequel l'étape de formation comprend en outre l'impression du premier ensemble de marques tracées (102, 130) sur une couche de surface de la tranche (96) associée au premier motif imprimé de design, et l'impression du deuxième ensemble de marques tracées (110, 140) sur la couche de surface de la tranche (96) associée au deuxième motif de design, de sorte que les premier et deuxième ensembles de marques tracées (102, 110, 130, 140) réticulent pour former l'ensemble composite de marques tracées (98a, 98b).

4. Procédé selon la revendication 3, dans lequel l'ensemble composite de marques tracées est un premier ensemble composite de marques tracées (98a), le procédé comprenant en outre les étapes de formation d'un deuxième ensemble composite de marques tracées (98b) à partir d'un troisième et d'un quatrième ensemble de marques tracées (130, 140), le deuxième ensemble de marques tracées (98b) présentant une caractéristique géométrique correspondant à un autre centroïde formé par agrégation des centroïdes respectifs du troisième et du quatrième ensemble de marques tracées (130, 140), les caractéristiques géométriques des premier et deuxième ensembles composites de marques tracées (98a, 98b) respectivement à même d'être employés pour limiter sensiblement l'erreur de rotation de réticule.

5. Procédé selon la revendication 4, comprenant en outre les étapes de détermination d'une marque virtuelle de référence (162) en fonction de caractéristiques géométriques respectives (126, 154) des premier et deuxième ensembles composites de marques tracées (98a, 98b) et à l'aide de la marque virtuelle de référence (162) pour faciliter l'alignement relatif entre la tranche (96) et le réticule (50).

6. Procédé de facilitation de l'alignement d'une tranche, comprenant les étapes suivantes :
utilisation d'un réticule (50) comprenant :
une surface de design (54) ;
un premier ensemble de marques tracées (60, 62) ; et
un deuxième ensemble de marques tracées (64, 66), symétrique par rapport au premier ensemble de marques tracées (60, 62) par rapport à la surface de design (54) ;
l'impression des premier et deuxième ensembles de marques tracées (60, 62, 64, 66) sur une couche de surface d'une tranche (96) associée à un premier emplacement de champ ; et
l'impression des premier et deuxième ensembles de marques tracées (60, 62, 64, 66) sur la couche de surface de la tranche (96) associée à un deuxième emplacement de champ adjacent au premier emplacement de champ, de sorte que le premier ensemble de marques tracées imprimées du premier emplacement de champ et le deuxième ensemble de marques tracées imprimées du deuxième emplacement de champ forment un ensemble composite de marques tracées imprimées (98a, 98b) qu'on est à même d'employer pour annuler sensiblement l'erreur de rotation associée au réticule (50) employé au cours d'un procédé d'impression lithographique, **caractérisé en ce que** chacun des premier et deuxième ensembles de marques tracées (60, 62, 64, 66) comporte un centroïde respectif (108, 114, 136, 144), la caractéristique géométrique de l'ensemble composite de marques tracées (98a, 98b) étant un centroïde (126, 154) formé par agrégation des centroïdes respectifs (108, 114, 136, 144) des premier et deuxième ensembles de marques tracées (60, 62, 64, 66) tels qu'ils sont imprimés.

7. Réticule (50) utile au cours d'un procédé lithographique, comprenant :
une surface de design (54) ;
un premier ensemble de marques tracées (60, 62) situé le long d'un premier côté de la surface de design ; et
un deuxième ensemble de marques tracées (64, 66) situé le long d'un deuxième côté de la surface de design opposée au premier côté, les premier et deuxième ensembles de marques tracées (60, 62, 64, 66) suivant une symétrie associée par rapport à la surface de design (54), si bien que lorsqu'on les imprime sur les champs adjacents d'une tranche, le premier ensemble de marques tracées imprimées d'un des champs adjacents et le deuxième ensemble de marques tracées imprimées d'un autre des champs adjacents réticulent pour former un ensemble composite de marques tracées imprimées (98a, 98b) sur la tranche qu'on est à même d'employer pour annuler sensiblement l'erreur de rotation associée à l'emploi du réticule lors d'un procédé d'impression lithographique ;
**caractérisé en ce que** chacun des premier et deuxième ensembles de marques tracées (60, 62, 64, 66) comporte un centroïde respectif (108, 114, 136, 144), la caractéristique géométrique de l'ensemble composite de marques tracées (98a, 98b) étant un centroïde (126, 154) formé par agrégation des centroïdes respectifs (108, 114, 136, 144) des premier et deuxième ensembles de marques tracées (60, 62, 64, 66) tels qu'ils sont imprimés.

8. Système de facilitation de l'alignement de tranches, comprenant :
un réticule (50) comprenant :
une surface de design (54) ;
un premier ensemble de marques tracées (60, 62) situé le long d'un premier côté de la surface de design ; et
un deuxième ensemble de marques tracées (64, 66) situé le long d'un deuxième côté de la surface de design, symétrique par rapport au premier ensemble de marques tracées par rapport à la surface de design ;
au moins un système (200) permettant de localiser un ensemble composite de marques tracées telles qu'elles sont imprimées sur une couche de surface de la tranche, l'ensemble composite de marques tracées étant formé par agrégation du premier ensemble de marques tracées telles qu'elles sont imprimées sur la couche de surface de la tranche associée à un premier emplacement de champ, et du deuxième ensemble de marques tracées telles qu'elles sont imprimées sur la couche de surface de la tranche associée à un deuxième emplacement de champ, adjacent au premier emplacement de champ ; et
un processeur (270) permettant de commander les opérations générales de l'au moins un système (200), le processeur (270) étant configuré pour déterminer une caractéristique géométrique de l'ensemble composite de marques tracées (98a, 98b), le processeur (270) employant la caractéristique géométrique en vue de faciliter l'alignement respectif de la tranche (96) et du réticule (50) ; dans lequel la caractéristique géométrique est un centroïde de l'ensemble composite de marques tracées (98a, 98b), **caractérisé en ce que** chacun des premier et deuxième ensembles de marques tracées (60, 62, 64, 66) contient un centroïde respectif (108, 114, 136, 144), la caractéristique géométrique de l'ensemble composite de marques tracées (98a, 98b) étant un centroïde (126, 154) formé par agrégation des centroïdes respectifs (108, 114, 136, 144) des premier et deuxième ensembles de marques tracées (60, 62, 64, 66) tels qu'ils sont imprimés.

9. Système selon la revendication 8, comprenant en outre :
un moyen de localisation d'un ensemble composite de marques tracées sur une couche de surface de la tranche, l'ensemble composite de marques tracées étant formé d'un premier et d'un deuxième ensemble de marques tracées imprimées sur la couche de surface de la tranche respectivement associée aux premier et deuxième champs adjacents, les premier et deuxième ensembles de marques tracées imprimées présentant une symétrie associée telle que l'ensemble composite de marques tracées annule pratiquement l'erreur de rotation du réticule ;
un moyen de détermination de la caractéristique géométrique de référence de l'ensemble composite de marques tracées, la caractéristique géométrique de référence étant une marque d'alignement virtuel ; et
un moyen d'alignement de la tranche utilisant la marque virtuelle d'alignement en tant que référence.
